# EUROPÄISCHE PATENTSCHRIFT

(11) **EP 1 067 679 B1**
(45) Veröffentlichungstag und Bekanntmachung des Hinweises auf die Patenterteilung: **06.12.2006**
(21) Anmeldenummer: 00113938.5
(22) Anmeldetag: 30.06.2000
(51) Int. Cl.: H03F 3/45, H03F 3/72

(54) **Differenzverstärker**
Differential amplifier
Amplificateur différentiel

(30) Priorität: 30.06.1999 DE 19930171
(43) Veröffentlichungstag der Anmeldung: 10.01.2001
(73) Patentinhaber: Infineon Technologies AG, 81669 München (DE)
(72) Erfinder: Ganser, Siegfried, 85570 Markt Schwaben (DE)
(74) Vertreter: Epping - Hermann - Fischer

(56) Entgegenhaltungen:
- EP-A- 0 810 723
- FR-A- 2 672 748
- US-A- 4 520 324
- US-A- 5 894 245

## Beschreibung

Die Erfindung betrifft einen Differenzverstärker als integrierten Baustein (IC) mit einem Gegentakteingang, einem Gegentaktausgang, zwei Transistor-Verstärkerstufen und zwei Kaskodestufen.

Ein ähnlicher Differenzverstärker ist beispielsweise aus "Halbleiter-Schaltungstechnik", Seiten 392, Abb. 4.74, Tietze/Schenk, 11. Auflage, Springer-Verlag, bekannt. Bei diesem bekannten Differenzverstärker handelt es sich um einen Kaskode-Differenz-Verstärker.

Im Mobilfunk werden bisher im Stand der Technik einfache Verstärkerstufen eingesetzt, die in der Regel aus rauscharmen Einzeltransistoren bestehen, wobei eine notwendige Spiegelfrequenzunterdrückung durch ein passives Filter vor dem Verstärker und durch ein weiteres passives Filter vor dem nachgeschalteten Mischer stattfindet. Die notwendige Frequenzselektion erfolgte also außerhalb des Verstärkers, der diskret oder integriert ausgeführt ist.

Da die Mobilfunkgeräte und damit auch die Bausteine dieser Geräte einer immer stärkeren Miniaturisierung unterliegen, ist man bestrebt, die Bausteine in einer möglichst kompakten Ausführung aufzubauen.

In der US 5 352 987 ist ein analoger Multiplexer gezeigt, der einen Differenzverstärker mit zwei Transistor-Verstärkerstufen aufweist sowie daran gekoppelte jeweilige Kaskodestufen, an die ein Gegentaktausgang angeschlossen ist. Ein Multiemittertransistor ist an die Verstärkerstufen angeschlossen und dient zur Umschaltung zwischen mehreren solchen Differenzverstärkerstufen.

In der EP 0810723 A1 ist ein BICMOS Differenzverstärker gezeigt, der ebenfalls zwei Transistor-Verstärkerstufen und daran gekoppelte Kaskodestufen aufweist. Über an die Kaskodestufen angeschlossene Schalteinrichtungen lassen sich Verbindungen von parasitären Kapazitäten des Differenzverstärkers umschalten.

Es ist daher Aufgabe der Erfindung, einen hochintegrierten Verstärker zur Verfügung zu stellen, der geeignet ist, eine bestimmte Frequenz möglichst rauscharm zu verstärken.

Diese Aufgabe der Erfindung wird durch die Merkmale des Anspruches 1 gelöst.

Demgemäß schlägt der Erfinder vor, den bekannten Differenzverstärker als integrierten Baustein mit einem Gegentakteingang, einem Gegentaktausgang, zwei Transistor-Verstärkerstufen und zwei Kaskodestufen, die mit einem Umschalter schaltbar sind, dahingehend zu verbessern, daß auf dem integrierten Baustein eine Selektionsschaltung vorhanden ist, welche einen Schwingkreis aufweist und die Verstärkung auf eine bestimmte Frequenz beschränkt.

Vorteilhaft ist der Differenzverstärker so aufgebaut, daß die beiden Kaskodestufen symmetrisch aufgebaut sind.

Der Schwingkreis kann vorzugsweise mindestens einen Kondensator und mindestens eine Spule aufweisen.

Die bevorzugte Bauweise der mindestens einen Spule besteht darin, daß sie als plane Schleife einer oder mehrere Leiterbahn(en) im integrierten Baustein (IC) integriert ist.

Eine weitere bevorzugte Ausführungsform des erfindungsgemäßen Kaskode-Differenzverstärker besteht darin, daß die Bias-Versorgung der Transistoren mindestens einer Verstärkerstufe eine integrierte Bandgapschaltung und gegebenenfalls einen nachgeschalteten Operationsverstärker aufweist. Die Bandgapschaltung bezeichnet eine integrierte Spannungsversorgung, die eine von der Temperatur und der Versorgungsspannung unabhängige Referenzspannung zur Verfügung stellt.

Zusätzlich oder alternativ kann auch die Bias-Versorgung der Transistoren mindestens einer Kaskodestufe eine entsprechende, integrierte Bandgapschaltung und gegebenenfalls einen nachgeschalteten Operationsverstärker vorsehen.

Eine weitere Ausgestaltung des erfindungsgemäßen Differenzverstärkers besteht darin, daß in mindestens einer Verstärkerstufe, vorzugsweise in beiden Verstärkerstufen, eine Gegenkopplung, vorzugsweise eine Parallel-Gegenkopplung, mit mindestens je einem Widerstand und/oder mindestens einer Kapazität, vorgesehen ist.

Zusätzliche kann eine Ableitung des Signals am Gegentaktausgang (RFout, RFXout) über eine Kapazität und einen Widerstand vorgesehen werden.

Die Transistoren des Differenzverstärkers können sowohl als npn- oder pnp- oder auch als FET-Transistoren ausgestaltet sein.

Bisherige integrierte bekannte Lösungen für integrierte Schaltungen waren zwar schaltbar und rauscharm aber unsymmetrisch aufgebaut. Die Spiegelfrequenzunterdrückung erfolgte durch ein passives Filter vor dem LNA und durch ein passives Filter vor dem Mischer, das heißt die Frequenzselektion erfolgte außerhalb des IC's. Die Schaltungsanordnung des erfindungsgemäßen integrierten Bausteines stellt also erstmals einen integrierten, selektiv wirkenden, bezüglich seiner Verstärkung schaltbaren und rauscharme Kaskoden-Differenzverstärker zur Verfügung, der vorzugsweise als Vorverstärker von Empfangssignalen in Mobilfunk-Geräten eingesetzt wird und die Spiegelfrequenzunterdrückung bei konstanter Ein- und Ausgangsimpedanz unterstützt.

Es versteht sich, daß die vorstehend genannten und nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale der Erfindung ergeben sich aus den Unteransprüchen und der nachfolgenden Beschreibung des bevorzugten Ausführungsbeispiels unter Bezugnahme auf die Zeichnung.

Im folgenden wird die Erfindung anhand der Zeichnungen näher beschrieben:

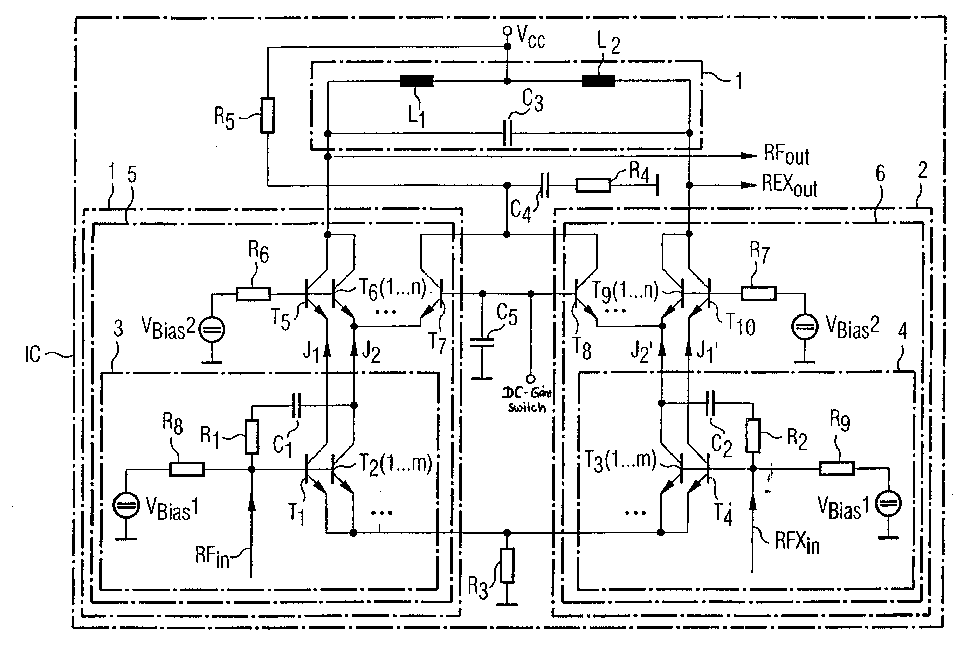

Figur 1: Erfindungsgemäße Schaltungsanordnung eines integrierten Bausteines.

Die Figur 1 zeigt eine bevorzugte Ausführungsform einer erfindungsgemäßen symmetrischen Schaltung eines integrierten elektronischen Bausteins mit einem Gegentakteingang RFin und RFXin, einem Gegentaktausgang RFout und RFXout, zwei Transistor-Verstärkerstufen 3 und 4, und zwei Kaskodestufen 5, 6 auf. Die Kaskodestufen 5 und 6 sind über einen DC-Gain-Switch umschaltbar ausgeführt. Weiterhin ist erfindungsgemäß auf dem integrierten Baustein eine Selektionsschaltung 1 vorgesehen, welche das verstärkte Signal auf ein bestimmtes Frequenzband filtert.

In dieser Schaltung bilden im Einzelnen die Transistoren T1 bis T4 die Verstärkerstufen 3 und 4, in dem der Widerstand R3 über die - aus Gründen der Übersichtlichkeit nicht eingezeichnete - Biasspannung an den Basen von T1 bis T4 den DC-Grundstrom der Schaltung regelt. Der Transistor T5 bildet die Kollektorlast von T1, die Transistoren T6(1...n) und T7 bilden die Kollektorlast des Transistors T2(1...m). Analog hierzu sind die Transistoren T10 für T4 und T9(1...n) und T8 für T3(1...m) zuständig.

Die Kollektoren der Transistoren T5, T6 (1...n) und T10, T9 (1...n) sind über die Selektionsschaltung 1 mit der Versorgungsspannung VCC verbunden. Die Selektionsschaltung 1 stellt einen Schwingkreis mit zwei Spulen L1, L2 und einer Kapazität C3 dar. Die Kollektoren der Transistoren T7 und T8 sind über den Widerstand R5 mit der Versorgungsspannung VCC verbunden.

Die Biasversorgung der Basen der Transistoren T5, T6 (1...n) und T10, T9 (1...n) ist ebenfalls zur besseren Übersichtlichkeit nicht eingezeichnet und wird über eine integrierte Bandgapschaltung mit einem nachgeschalteten Operationsverstärker oder nur eine Bandgapschaltung realisiert.

Die Basisspannung der Transistoren T7 und T8 kann über den gezeigten Dreileiterbus variiert werden. Ist diese Basisspannung so klein, daß die Transistoren T7 und T8 sperren, wird das gesamte HF-Signal verstärkt an den Ausgang gegeben. Wird die Basisspannung an die Transistoren T7 und T8 so groß, daß diese leiten, wird nur noch ein Teil HF-Eingangssignals verstärkt und durch die Transistoren T5 und T10 an den Ausgang gegeben. Das heißt, ein (n+1)-tel des HF-Eingangssignales wird an den Ausgang gegeben, wobei n der Anzahl der parallelgeschalteten Transistoren T6(1...n) oder T9(1...n)entspricht.

Der Kondensator C3 bildet mit L1 und L2 einen Schwingkreis, welcher über seine Güte die von den Eingängen RFin und RFXin kommenden verstärkten Eingangssignale vorselektiert. Das Ausgangssignal wird an den Ausgängen RFout und RFXout abgegriffen.

Die Serienschaltung von R1 und C1 sowie R2 und C2 dient als Parallelgegenkopplung zur Erniedrigung der Eingangsimpedanz und damit zur Erhöhung der Linearität des Verstärkers. Sie greift die zugeordneten Signale jeweils am Kollektor des Transistors T2(1...n) beziehungsweise am Kollektor des Transistors T3(1...n) ab. Alternativ ist auch eine rein resistive oder eine rein kapazitive Gegenkopplung, oder ein Abgriff am Kollektor von T1 bzw. T4 ohne wesentliche Funktionseinschränkung möglich.

Da die Transistoren T2(1...n) beziehungsweise T3(1...n) immer Strom führen, wird eine Verstärkungsänderung keine Beeinflussung der Gegenkopplung nach sich ziehen. Eine Erhöhung der Basisspannung der Transistoren T7 und T8 soweit, daß diese Transistoren leitfähig werden, führt zu einer Ableitung des DC- und AC-Signales über die Transistoren T7, T8 und R5 nach VCC.

Um Reflektionen des verstärkten und abgeleiteten AC-Signales auf die Schaltung und Schwankungen auf der Versorgung zu vermeiden, wird außerdem eine Ableitung des RF-Signals über die Kapazität C4 und den Widerstand R4 nach Masse vorgesehen. Die Zahl n gibt die Anzahl der als T6 und T9 parallelgeschalteten und die Zahl m gibt die Anzahl der als T2 und T3 parallelgeschalteten Transistoren an, die entsprechend den Anforderungen an den Differenzverstärker zwischen 1 und einer beliebig hohen Anzahl variieren kann.

Durch diese Paralleltransistoren wird das Stromschaltverhältnis I1/I2 beziehungsweise I1'/I2' für die maximale und minimale Verstärkung definiert. Die maximal mögliche Verstärkungsänderung berechnet sich zu ΔGain=20log((n+1)/1). Für n=9 gilt deshalb ΔGain=20dB.

Die quasiparallelgeschalteten Transistoren T1 und T2(1...n) beziehungsweise T3(1...n) und T4 führen also in beiden Verstärkungszuständen Strom, das heißt, ein Schalten der Verstärkung führt auf vorteilhafte Weise zu keiner Änderung der Eingangsimpedanz. Die Ausgangsimpedanz wird durch die Selektionsschaltung 1, bestehend aus einem Parallelschwingkreis aus der Kapazität C3 und den Spulen L1/L2 bestimmt, beziehungsweise durch dessen Güte. Diese Güte ist sehr klein, daher bewirkt eine Änderung der Verstärkung auch keine wesentliche Änderung der Ausgangsimpedanz.

Die Verstärkerstufen weisen jeweilige parallel geschaltete Strompfade auf. Die Strompfade werden in der in der Figur links dargestellten Verstärkerstufe durch die bezüglich ihrer Kollektor-Emitter-Pfade in Reihe geschalteten Transistoren T5, T1 bzw. T6, T2 gebildet. Die Transistoren T1, T2 sowie T5, T6 werden jeweils parallel angesteuert, indem ihre Basisanschlüsse miteinander verbunden sind. Die Kaskodestufe einer der Strompfade, nämlich die den Transistor T6 umfassende Kaskodestufe, ist als Stromschalter ausgebildet und umfaßt zwei emitterseitig gekoppelte Transistoren T6, T7. Die in Figur 1 rechts dargestellte Verstärkerstufe weist einen dazu symmetrischen Aufbau auf. Die Kaskodestufen der beiden Verstärkerzweige sind durch den Umschalter in der Weise gekoppelt, daß die Transistoren T7, T8 basis- und kollektorseitig miteinander verbunden sind, wobei das Steuersignal DC-Gain-Switch an den gekoppelten Basisanschlüssen angelegt wird.

Die Kapazität C5, die zwischen den beiden Transistoren T7 und T8 angeordnet ist, dient hier zur Abblockung von störenden Frequenzen. Die Widerstände R6 bis R9 dienen zur Entkopplung des Verstärkers von den anliegenden Bias-Spannungen.

Insgesamt wird durch die oben beschriebene Schaltung eine wesentliche Miniaturisierung eines selektiven, schaltbaren und rauscharmen Differenzverstärkers, vorzugsweise zur Vorverstärkung von Empfangssignalen im Mobilfunk, erreicht, der unterstützend zur Unterdrückung von Spiegelfrequenzen wirkt und eine konstante Ein- und Ausgangsimpedanz aufweist.

## Patentansprüche

1. Differenzverstärker als integrierter Baustein (IC) mit einem Gegentakteingang (RFin, RFXin), der an je eine Transistor-Verstärkerstufe (3, 4) angeschlossen ist, und einem Gegentaktausgang (RFout, RFXout), der an je eine Kaskodestufe (5, 6) angeschlossen ist, die jeweils mit einer der Transistor-Verstärkerstufen (3, 4) verbunden sind,
wobei die Kaskodestufen (5, 6) jeweils über einen Umschalter (T6, ...,T9), gekoppelt sind,
**dadurch gekennzeichnet, dass**
auf dem integrierten Baustein (IC) eine Selektionsschaltung (1) vorgesehen ist, welche einen Schwingkreis aufweist und die Verstärkung auf eine bestimmte Frequenz beschränkt.

2. Differenzverstärker gemäß Anspruch 1,
**dadurch gekennzeichnet, daß** die beiden Kaskodestufen (5, 6) symmetrisch aufgebaut sind.

3. Differenzverstärker gemäß Anspruch 1 oder 2,
**dadurch gekennzeichnet, daß** der Schwingkreis mindestens einen Kondensator (C2) und mindestens eine Spule (L1, L2) aufweist.

4. Differenzverstärker gemäß Anspruch 3,
**dadurch gekennzeichnet, daß** die mindestens eine Spule (L1, L2) als plane Schleife einer oder mehrerer Leiterbahnen im integrierten Baustein (IC) integriert ist.

5. Differenzverstärker gemäß einem der Ansprüche 1 bis 4,
**dadurch gekennzeichnet, daß** die Bias-Versorgung der Transistoren mindestens einer Verstärkerstufe (3 mit T1, T2(1...n), 4 mit T4, T3(1...n)) eine integrierte Bandgapschaltung und gegebenenfalls einen nachgeschalteten Operationsverstärker aufweist.

6. Differenzverstärker gemäß einem der Ansprüche 1 bis 5,
**dadurch gekennzeichnet, daß** die Bias-Versorgung der Transistoren mindestens einer Kaskodestufe (5 mit T5, T6(1...n), 6 mit T10, T9(1...n)) eine integrierte Bandgapschaltung und gegebenenfalls einen nachgeschalteten Operationsverstärker aufweist.

7. Differenzverstärker gemäß einem der Ansprüche 1 bis 6,
**dadurch gekennzeichnet, daß** in mindestens einer Verstärkerstufe (3, 4), vorzugsweise beiden Verstärkerstufen (3, 4) eine Gegenkopplung, vorzugsweise eine Parallel-Gegenkopplung mit mindestens je einem Widerstand (R1, R2) und/oder einer Kapazität (R2, C2), vorgesehen ist.

8. Differenzverstärker gemäß einem der Ansprüche 1 bis 7,
**dadurch gekennzeichnet, daß** eine Ableitung des Signals am Gegentaktausgang (RFout, RFXout) über eine Kapazität (C4) und einen Widerstand (R4) vorgesehen ist.

9. Differenzverstärker gemäß einem der Ansprüche 1 bis 8,
**dadurch gekennzeichnet, daß** mindestens ein Transistor des Differenzverstärkers, vorzugsweise alle Transistoren des Differenzverstärkers, als npn-Transistor(en) ausgebildet ist/sind.

10. Differenzverstärker gemäß einem der Ansprüche 1 bis 9,
**dadurch gekennzeichnet, daß** mindestens ein Transistor des Differenzverstärkers, vorzugsweise alle Transistoren des Differenzverstärkers, als pnp-Transistor(en) ausgebildet ist/sind.

11. Differenzverstärker gemäß einem der Ansprüche 1 bis 10,
**dadurch gekennzeichnet, daß** mindestens ein Transistor des Differenzverstärkers, vorzugsweise alle Transistor(en) des Differenzverstärkers, als FET-Transistor(en) ausgebildet ist/sind.

12. Differenzverstärker gemäß einem der Ansprüche 1 bis 11,
**dadurch gekennzeichnet, daß** die Verstärkerstufen (3, 4) jeweils parallel geschaltete Pfade (T1, T5; T2, T6; T3, T9; T4, T10) mit je einer Transistor-Verstärkerstufe (T1, T2, T3, T4) und einer Kaskodestufe (T5, T6, T9, T10) umfassen, daß die parallel geschalteten Pfade Transistoren enthalten, die parallel ansteuerbar sind.

13. Differenzverstärker gemäß einem der Ansprüche 1 bis 12,
**dadurch gekennzeichnet, daß** der Umschalter in jeder der Kaskodestufen mindestens zwei emittergekoppelte Transistoren (T6, T7; T8, T9) umfaßt, und daß einer der Transistoren (T7) einer der Kaskodestufen mit einem der Transistoren (T8) einer anderen der Kaskodestufen kollektorseitig und basisseitig miteinander gekoppelt sind.

## Claims

1. Differential amplifier as an integrated module (IC) with a push-pull input (RFn, RFXn), which is coupled to a respective transistor amplifier stage (3, 4) and a push-pull output (RFout, RFXout) which is coupled to a respective cascode stage (5, 6), which are each coupled to one of the transistor amplifier stages (3, 4), the cascode stages (5, 6) each being coupled via a changeover switch (T6, ..., T9),
**characterized in that**
a selection circuit (1) is provided on the integrated module (IC), which selection circuit comprises a resonant circuit and restricts the gain to a specific frequency.

2. Differential amplifier according to one of the preceding claims 1, **characterized in that** the two cascode stages (5, 6) are constructed in a balanced manner.

3. Differential amplifier according to one of the preceding claims 1 or 2, **characterized in that** the resonant circuit has at least one capacitor (C2) and at least one coil (L1, L2).

4. Differential amplifier according to claim 3, **characterized in that** the at least one coil (L1, L2) is integrated as a planar loop of one or more interconnect(s) in the integrated module (IC).

5. Differential amplifier according to one of claims 1 to 4, **characterized in that** the bias supply of the transistors of at least one amplifier stage (3 with T1, T2 (1..n), 4 with T4, T3 (1...n)) has an integrated bandgap circuit and, if appropriate, an operational amplifier connected downstream.

6. Differential amplifier according to one of claims 1 to 5, **characterized in that** the bias supply of the transistors of at least one cascode stage (5 with T5, T6 (1....n), 6 with T10, T9 (1...n)) comprises an integrated bandgap circuit and, if appropriate, an operational amplifier connected downstream.

7. Differential amplifier according to one of claims 1 to 6, **characterized in that** negative feedback, preferably parallel negative feedback with at least one resistor (R1, R2) and/or one capacitance element (C1, C2) in each case, is provided in at least one amplifier stage (3, 4), preferably both amplifier stages (3, 4).

8. Differential amplifier according to one of claims 1 to 7, **characterized in that** provision is made for conducting away the signal at the push-pull output (RFout, RFXout) via a capacitance element (C4) and a resistor (R4).

9. Differential amplifier according to one of claims 1 to 8, **characterized in that** at least one transistor of the differential amplifier, preferably all the transistors of the differential amplifier, is/are designed as npn transistor(s).

10. Differential amplifier according to one of claims 1 to 9, **characterized in that** at least one transistor of the differential amplifier, preferably all the transistors of the differential amplifier, is/are designed as pnp transistor(s).

11. Differential amplifier according to one of claims 1 to 10, **characterized in that** at least one transistor of the differential amplifier, preferably all the transistors of the differential amplifier, is/are designed as FET transistor(s).

12. Differential amplifier according to one of claims 1 to 11, **characterized in that** the amplifier stages (3, 4) each comprise parallel-connected paths (T1, T5; T2, T6; T3, T9; T4, T10) respectively having a transistor amplifier stage (T1, T2, T3, T4) and a cascode stage (T5, T6, T9, T10), and **in that** the parallel-connected paths comprise transistors which can be driven in parallel.

13. Differential amplifier according to one of claims 1 to 12, **characterized in that** the changeover switch in each of the cascode stages comprises at least two emitter-coupled transistors (T6, T7; T8, T9), and **in that** one of the transistors (T7) of one of the cascode stages and one of the transistors (T8) of another of the cascode stages are coupled to one another by their collectors and bases.

## Revendications

1. Amplificateur différentiel en tant que module intégré (IC) comportant une entrée (RFin, RFXin) à montage symétrique, qui est reliée à un étage (3, 4) de transistor amplificateur, et une sortie (RFout, RFXout) à montage symétrique, qui est reliée à un étage (5, 6) cascode, qui sont chacune reliées respectivement à l'un des étages (3, 4) de transistor amplificateur, les étages (5, 6) cascodes étant respectivement couplés par l'intermédiaire d'un commutateur (T6, ..., T9),
**caractérisé en ce qu'**il est prévu, sur le module intégré (IC), un circuit (1) de sélection, qui comporte un circuit oscillant et qui limite l'amplification à une fréquence déterminée.

2. Amplificateur différentiel suivant la revendication 1,
**caractérisé en ce que** les deux étages (5, 6) cascodes sont symétriques.

3. Amplificateur différentiel suivant la revendication 1 ou 2,
**caractérisé en ce que** le circuit oscillant comporte au moins un condensateur (C2) et au moins une bobine (L1, L2).

4. Amplificateur différentiel suivant la revendication 3,
**caractérisé en ce que** ladite au moins une bobine (L1, L2) est intégrée dans le module intégré (IC) sous la forme d'une boucle plane d'une ou plusieurs voies conductrices.

5. Amplificateur différentiel suivant l'une des revendications 1 à 4,
**caractérisé en ce que** l'alimentation de polarisation des transistors d'au moins un étage d'amplificateur (3 avec T1, T2(1...n), 4 avec T4, T3(1...n)) comporte un circuit intégré à bandgap et éventuellement un amplificateur opérationnel monté en aval.

6. Amplificateur différentiel suivant l'une des revendications 1 à 5,
**caractérisé en ce que** l'alimentation de polarisation des transistors d'au moins un étage (5 avec T5, T6(1...n), 6 avec T10, T9(1...n)) de cascode comporte un circuit à bandgap et éventuellement un amplificateur opérationnel monté en aval.

7. Amplificateur différentiel suivant l'une des revendications 1 à 6,
**caractérisé en ce que**, dans au moins un étage (3, 4) amplificateur, de préférence les deux étages (3, 4) amplificateurs, il est prévu un contre-couplage, de préférence un contre-couplage parallèle, comportant au moins respectivement une résistance (R1, R2) et/ou une capacité (R2, C2).

8. Amplificateur différentiel suivant l'une des revendications 1 à 7,
**caractérisé en ce qu'**une dérivation du signal est prévue à la sortie à montage symétrique (RFout, RFXout) par une capacité (C4) et une résistance (R4).

9. Amplificateur différentiel suivant l'une des revendications 1 à 8,
**caractérisé en ce qu'**au moins un transistor de l'amplificateur différentiel, de préférence tous les transistors de l'amplificateur différentiel, est/sont réalisé(s) sous la forme de transistor(s) npn.

10. Amplificateur différentiel suivant l'une des revendications 1 à 9,
**caractérisé en ce qu'**au moins un transistor de l'amplificateur différentiel, de préférence tous les transistors de l'amplificateur différentiel, est/sont réalisé(s) sous la forme d'un ou de transistors pnp.

11. Amplificateur différentiel suivant l'une des revendications 1 à 10,
**caractérisé en ce qu'**au moins un transistor de l'amplificateur différentiel, de préférence tous les transistors de l'amplificateur différentiel, est/sont réalisé(s) sous la forme d'un ou de transistors FET.

12. Amplificateur différentiel suivant l'une des revendications 1 à 11,
**caractérisé en ce que** les étages (3, 4) amplificateurs comportent des voies (T1, T5 ; T2, T6 ; T3, T9 ; T4, T10) en parallèle comportant respectivement un étage (T1, T2, T3, T4) amplificateur transistor et un étage (T5, T6, T9, T10) cascode, et **en ce que** les voies en parallèle comportent des transistors qui peuvent être commandés en parallèle.

13. Amplificateur différentiel suivant l'une des revendications 1 à 12,
**caractérisé en ce que** le commutateur comporte, dans chacun des étages cascodes, au moins deux transistors (T6, T7 ; T8, T9) montés en émetteur, et **en ce que** l'un des transistors (T7) de l'un des étages cascodes et l'un des transistors (T8) d'un autre des étages cascodes sont couplés mutuellement du côté collecteur et du côté de la base.
